(19) **Europäisches Patentamt / European Patent Office / Office européen des brevets**

(11) **EP 4 756 443 A2**

(12) # EUROPEAN PATENT APPLICATION

(43) Date of publication:
**10.06.2026 Bulletin 2026/24**

(21) Application number: **26169694.2**

(22) Date of filing: **31.03.2026**

(51) International Patent Classification (IPC):
**G01R 31/28** $^{(2006.01)}$

(52) Cooperative Patent Classification (CPC):
**G01R 31/2884; G01R 31/2851**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicants:
• **NXP B.V.**
  **5656 AG Eindhoven (NL)**
• **Technische Universiteit Eindhoven**
  **5612 AE Eindhoven (NL)**

(72) Inventors:
• **Tunca, Can**
  **5656AG Eindhoven (NL)**
• **van Veldhoven, Robert**
  **5656AG Eindhoven (NL)**

(74) Representative: **Colaiuda, Antonella**
**NXP Semiconductors Germany GmbH**
**Intellectual Property Group**
**Beiersdorfstraße 12**
**22529 Hamburg (DE)**

(54) **PROCESS VARIATION SENSOR**

(57) One example discloses a process sensor, including: a set of process sensitive current sources having a set of transistors embedded in a semiconductor device; wherein the process sensitive current sources are configured to generate an output current that varies in response to a process parameter shift of the transistors in the semiconductor device; a ring oscillator coupled to receive the output current from the set of process sensitive current sources; wherein the ring oscillator is configured to generate an output signal having a frequency that varies in response to the output current.

Fig. 1

**EP 4 756 443 A2**

**Description**

The present specification relates to systems, methods, apparatuses, devices, articles of manufacture and instructions for sensing process variations.

SUMMARY

According to an example embodiment, a process sensor, comprising: a set of process sensitive current sources having a set of transistors embedded in a semiconductor device; wherein the process sensitive current sources are configured to generate an output current that varies in response to a process parameter shift of the transistors in the semiconductor device; a ring oscillator coupled to receive the output current from the set of process sensitive current sources; wherein the ring oscillator is configured to generate an output signal having a frequency that varies in response to the output current.

In another example embodiment, the set of process sensitive current sources include an NMOS process sensitive current source.

In another example embodiment, the set of process sensitive current sources include a PMOS process sensitive current source.

In another example embodiment, the set of process sensitive current sources include a resistance process sensitive current source.

In another example embodiment, a resistance in the resistance process sensitive current source is formed from a switched-capacitance device.

In another example embodiment, the process sensitive current sources are beta-multiplier current sources.

In another example embodiment, the process sensitive current sources are PTAT (proportional to absolute temperature) current sources.

In another example embodiment, further comprising a controller configured to select which one of the set of process sensitive current sources is routed to the ring oscillator.

In another example embodiment, the controller is configured to receive a first command to route a first one of the set of process sensitive current sources to the ring oscillator so that the frequency of the output signal corresponds to a first set of process corners of a first sub-set of the transistors; and the controller is configured to receive a second command to route a second one of the set of process sensitive current sources to the ring oscillator so that the frequency of the output signal corresponds to a second set of process corners a second sub-set of the transistors.

In another example embodiment, the controller is configured to receive a third command to route a third one of the set of process sensitive current sources to the ring oscillator so that the frequency of the output signal corresponds to a third set of process corners of a set of polysilicon resistors.

In another example embodiment, the controller is configured to receive a third command to route a third one of the set of process sensitive current sources to the ring oscillator so that the frequency of the output signal corresponds to a third set of process corners of a set of switched capacitors configured as a resistance.

In another example embodiment, the first sub-set of the transistors are NMOS transistor; and the second sub-set of the transistors are PMOS transistor.

In another example embodiment, the first and second set of process corners include typical-typical (TT), fast-fast (FF), slow-slow (SS), fast-slow (FS), and slow-fast (SF); and fast and slow refer to a switching speed of NMOS and PMOS transistors in the semiconductor device.

In another example embodiment, the first and second set of process corners are defined by a three letter tuple F, T, S that indicates a fast (F), a typical (T), or a slow (S) behavior for either the NMOS or PMOS transistors, or a set of polysilicon resistors; and the three letter tuples include at least one of: FFF, FFT, FST, TTT, SFT, SST, and SSS.

In another example embodiment, the ring oscillator is formed from a set of differential delay cells.

In another example embodiment, the differential delay cells are coupled to receive the output current from the process sensitive current sources.

In another example embodiment, further comprising a controller configured to receive a first command to select a first one of a set of load elements in the differential delay cells so that the frequency of the output signal corresponds to a first set of process corners of a first sub-set of the transistors; wherein the controller configured to receive a second command to select a second one of a set of load elements in the differential delay cells so that the frequency of the output signal corresponds to a second set of process corners of a second sub-set of the transistors.

In another example embodiment, the controller configured to receive a third command to select a third one of a set of load elements in the differential delay cells so that the frequency of the output signal corresponds to a third set of process corners of a set of polysilicon resistors or a set of switched capacitors configured as a resistance.

In another example embodiment, the controller is configured to, in response to the first command, route a first one of the set of process sensitive current sources to the ring oscillator so that the frequency of the output signal corresponds to

2

the first set of process corners of the first sub-set of the transistors; and the controller is configured to, in response to the second command, route a second one of the set of process sensitive current sources to the ring oscillator so that the frequency of the output signal corresponds to a second set of process corners a second sub-set of the transistors.

In another example embodiment, the controller is configured to, in response to the third command, route a third one of the set of process sensitive current sources to the ring oscillator so that the frequency of the output signal corresponds to a third set of process corners of a set of polysilicon resistances or a set of switched capacitors configured as a resistance.

In another example embodiment, further comprising, a controller; a switch circuit coupled between the process sensitive current sources, the ring oscillator, and the controller; and a comparator coupled to receive a differential output signal from the ring oscillator and generate the output signal.

In another example embodiment, the controller is configured to send a signal to the switch circuit to select which one of the set of process sensitive current sources is routed to the ring oscillator.

In another example embodiment, further comprising, a current mirror coupled between the switch circuit and the ring oscillator; and a buffer cell coupled between the ring oscillator and the comparator.

In another example embodiment, the ring oscillator is configured to route the output signal to a set of calibration circuits; and the calibration circuits tune the semiconductor device in response to the output signal.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

BRIEF DESCRIPTION OF THE DRAWINGS

Figure 1 represents an example process sensor circuit.
Figures 2A, 2B, 2C represent example process sensitive current sources.
Figure 3 represents an example delay cell.
Figure 4 represents an example alternative implementation of process sensitive current source.
Figure 5 represents example process sensor circuit output signal waveforms.
Figures 6A, 6B, 6C represent example correlations between the process sensor circuit's output signal frequency and process parameters that are being tracked/monitored.
Figures 7A, 7B, 7C represent example behavior of a process sensor circuit output frequency and across temperature and supply voltage changes.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the scope of the appended claims are covered as well.

DETAILED DESCRIPTION

CMOS process variations arise due to inherent tolerances in lithography and etching processes, as well as the fluctuations of doping concentrations and oxide thickness, which affect transistor electrical parameters such as threshold voltage (Vth), critical dimensions (W-L), and mobility ($\mu$) within a semiconductor device.

To account for these shifts and to predict the circuit performance at the extremes of the fabrication process window, statistical process corners are used, e.g., as input for the transistor models. Corner models are categorized based on the relative speed of NMOS and PMOS transistors respectively, resulting in combinations such as typical-typical (TT), fast-fast (FF), slow-slow (SS), fast-slow (FS), and slow-fast (SF), where fast and slow refer to a switching speed of the NMOS and PMOS transistors in the semiconductor device. Circuits that do not function properly at these corners have inadequate margins.

While simulations allow the prediction of circuit performance, practical implementations require knowledge of the actual process corner to enable effective calibration or post-correction techniques. Consequently, on-chip corner detection is increasingly employed to address the impact of process variations.

Standard-cell inverter-based ring oscillators are used in some of the most common process corner sensors. Their design is straightforward and compact; however, their output frequency can be sensitive to ambient temperature and supply voltage. Further, inverter-based process sensors can only detect even corners (FF, TT, SS) and can not distinguish between skewed (i.e. cross) corners (FS, SF).

Now discussed is an improved process sensor that can detect NMOS and PMOS process corners independently and is robust against temperature and supply voltage changes.

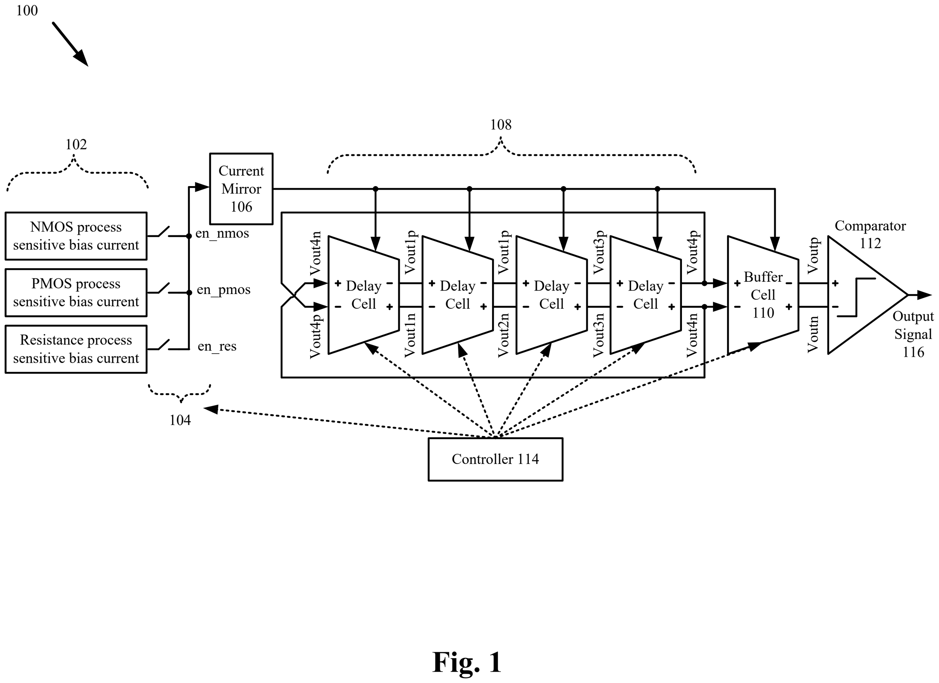

Figure 1 represents an example process sensor circuit 100. The process sensor 100 includes a set of process sensitive current sources 102, a switch circuit 104, a current mirror 106, a ring oscillator 108, a buffer cell 110, an asynchronous comparator 112, and a controller 114. The process sensitive current sources 102 (e.g. beta-multiplier current sources) include an NMOS process sensitive current source, a PMOS process sensitive current source, and a resistance process sensitive current source. The ring oscillator 108 includes a set of differential delay cells.

The process sensor circuit 100 generates an output signal 116. In many example embodiments, the output signal 116 is a digital signal having a frequency that is well correlated with process variations for a selected device type (e.g. NMOS, PMOS or polysilicon resistance) within a semiconductor device within which the set of process sensitive current sources 102 are embedded.

The output signal 116 is routed to a set of calibration circuits (not shown) that can tune the semiconductor device during testing/calibration of the semiconductor device.

The set of process sensitive current sources 102 are in various example embodiments PTAT (proportional to absolute temperature) currents which are, by design, heavily dependent on variations in process characteristics of the semiconductor device within which the set of process sensitive current sources 102 are embedded and that is being monitored. Previously a ring oscillators output frequency decreases with increasing temperature, as the transistors mobility degrades; however, using the PTAT trait of the process sensitive current sources 102, the ring oscillator's 108 temperature dependency is cancelled.

Process shifts are detected using threshold voltage and carrier mobility variations on MOS devices and sheet resistance variations of polysilicon resistances. Output currents from the set of process sensitive current sources 102 are routed to the switch circuit 104.

The controller 114 is configured to control the switch circuit 104 and select which one of the set of process sensitive current sources 102 are routed via the current mirror 106 to each of the differential delay cells in the ring oscillator 108. The controller 114 is itself controlled by commands from the set of calibration circuits (not shown) which tests the various process corners for each device type (i.e. NMOS, PMOS, Resistive) within the semiconductor device during testing/calibration of the semiconductor device.

A selected one of the set of process sensitive current sources 102 is mirrored and routed to each of the differential delay cells in the ring oscillator 108.

In various example embodiments, the ring oscillator 108 is a 4-stage differential current-controlled ring oscillator having switchable symmetric loads that in combination with the set of process sensitive current sources 102, is configured to monitor the process variations. The ring oscillator architecture is preferred in order to have the outputs on the digital domain.

The set of differential delay cells within the ring oscillator are designed using differential pairs with either diode connected NMOS and PMOS devices or polysilicon resistances. Voltage supply dependency of the process sensor circuit 100 is suppressed by the differential nature of the delay cells.

Temperature dependent variation in the output signal 116 frequency changes are mitigated by biasing the differential delay cells with a PTAT current from a selected one of the set of process sensitive current sources 102.

The buffer cell 110 receives the ring oscillator 108 output. The buffer cell 110 in various example embodiments is identical to the delay cells, and isolates the delay cell's internal nodes from any effects introduced by the comparator 112 (e.g. external parasitic capacitances).

The buffered differential delay cell signals are fed to the asynchronous comparator 112 which generates a digital output voltage (e.g. logic-0 and logic-1) levels.

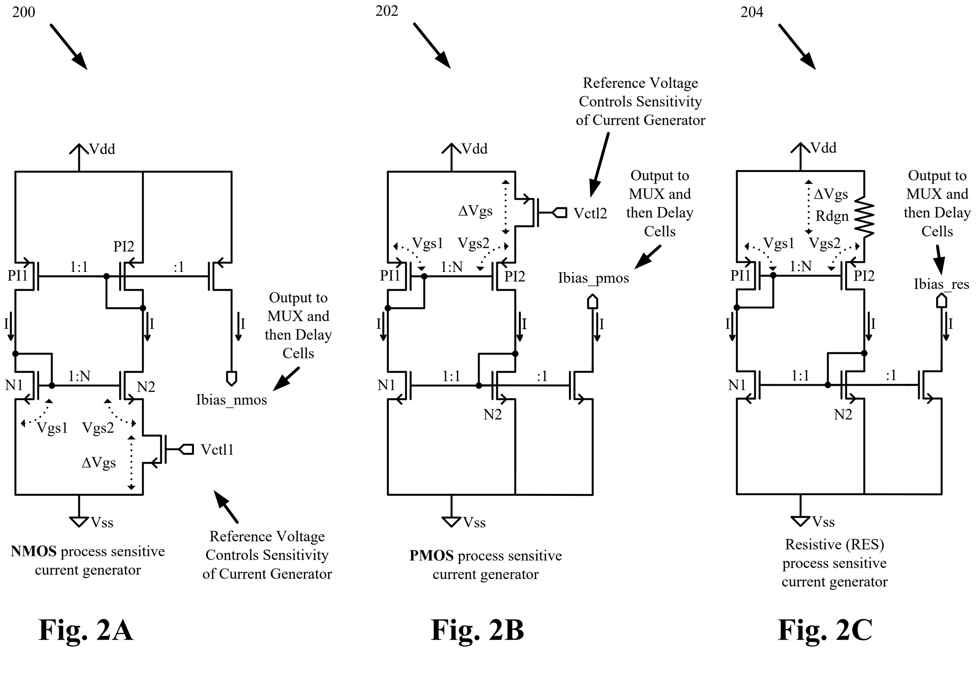

Figures 2A, 2B, 2C represent example process sensitive current sources 200, 202, 204. Figure 2A shows an example NMOS process sensitive current generator. Figure 2B shows an example PMOS process sensitive current generator. Figure 2C shows an example resistive (RES) process sensitive current generator.

These Figures show supply voltage (Vdd), ground reference (Vss), output current source (Ibias_nmos, Ibias_pmos, Ibias_res), and reference voltage for process sensitivity control (Vctl1, Vctl2). The output current source (Ibias_nmos, Ibias_pmos, Ibias_res) are routed to the switch circuit 104 in Figure 1. The process sensitive current sources 200, 202, 204 provide both process sensitive and PTAT currents to the ring oscillator 108 via the switch circuit 104.

In Figure 2A, the NMOS process sensitive current source 200 is produced using transistors P11 and P12 that in deep saturation and connected as a current mirror. As the current mirror makes the current on two branches equal, ΔVgs is proportional to the W/L ratio difference on N1 and N2. N1 and N2 are sized to operate on weak inversion thus the ΔVgs is process independent as expressed by the term at the numerator of the following equation:

$$I_{1,2} \approx \left(\frac{kT}{q} \ln\left(\frac{W_{N2}/L_{N2}}{W_{N1}/L_{N1}}\right)\right)/R_{degen}$$

, where k is Boltzmann's constant, T is temperature, and q is electron charge.

The source degeneration element can also be implemented as a resistor or a MOS device operating in the linear region. This defines the value and creates strong process dependency at the output current. If a process independent voltage at the is applied at the gate of the MOS devices operating in the linear region, the resistance becomes a strong function of Vth and mobility, thus altering the current generated by the beta multiplier current generator.

$$I_{1,2} \approx \left(\frac{kT}{q} \ln\left(\frac{W_{N2}/L_{N2}}{W_{N1}/L_{N1}}\right)\right) \times \left(\mu C_{ox}\frac{W}{L}(V_{gs} - V_{th})\right)$$

The value of Vctl1 is determined via considering the process sensitivity, the temperature coefficient and the value of the reference current generated by the beta multiplier circuitry. This voltage can derived using an internal bandgap voltage source or an external reference.

In Figure 2B, the PMOS process sensitive current source 202 is produced using a complementary circuit similar to Figure 2A as shown. Vctl2 is generated to bias PMOS device in linear region.

In Figure 2C, the resistive process sensitive current source 204 is produced by replacing the PMOS device operating in linear region. in Figure 2B with a degeneration resistance (Rdgn) as shown.

The gate control voltages Vctl1 and Vctl2 for the process sensitive current sources 200, 202, are set to optimize their process dependency and temperature coefficient. These gate control voltages can be obtained using an on-chip bandgap voltage source and resistive divider.

In some example embodiments, the degeneration resistance (Rdgn) can be fabricated with switched-capacitance devices that are functionally equivalent to a passive resistor.

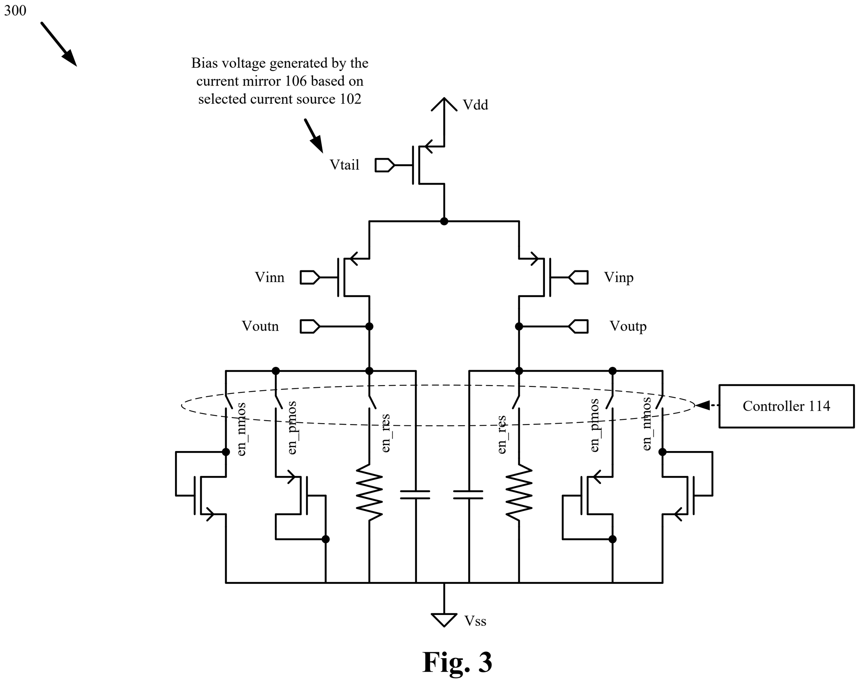

Figure 3 represents an example delay cell 300 within the set of differential delay cells as well as in the buffer cell 110.

The delay cell 300 receives a supply voltage (Vdd), ground reference (Vss), and Vtail (i.e. bias voltage generated by the current mirror according to (Ibias_nmos, Ibias_pmos, Ibias_res) the selected one of the process sensitive current sources 200, 202, 204.) The delay cell 300 also receive differential inputs from preceding delay stage (Vinn, Vinp) and generates differential outputs for the following delay stage. (Voutn, Voutp).

The controller 114 is coupled to enable a pair of switches (e.g. en_nmos, en_pmos, en_res) depending upon the process corner being measured. The controller 114 also sends the same signal to the switch circuit 104 (see Figure 1).

The delay cell 300 adopts a differential pair configured to receive a tail current (supplied by the PMOS device biased with Vtail) from the selected one of the process sensitive current sources 200, 202, 204. The delay cell 300 also includes switchable (e.g. en_nmos, en_pmos, en_res) load elements configured to be controlled by the controller 114.

These load elements can be configured with either diode connected MOS or polysilicon resistances to support operation across different modes. The input pair and the tail devices are implemented as PMOS devices. The tail current provided by the PMOS tail device is steered by the input pair towards the left or right branch, according to the previous stage output voltage. The delay cell's 300 output voltage swing (Vsw) depends on tail current value and the process variations on Vth or Rsheet. A propagation delay (td) generated by this cell is directly proportional to the Vsw.

Based on this circuit 300, the ring oscillator's 108 output signal 116 digital frequency can be expressed as:

$$f_{out} \approx \frac{1}{2Nt_d} \approx \frac{I_{tail}}{2NC_{load}V_{sw}}$$

, where Itail is the value of the tail current of the single delay stage, N is the number of delay stages in the ring oscillator, Cload is the output capacitance of the single delay cell.

The value of the Cload is typically determined by a gate capacitance of a next delay cell's input transistors. A gate capacitance of the MOS transistor, however, is voltage dependent; as the overdrive voltage of the PMOS devices varies due to its process shifts, Cload changes accordingly, negatively impacting the accuracy of the process sensor on NMOS and resistance process sensing modes. To mitigate this, size of the PMOS devices is reduced (and only limited due mismatch considerations) and two relatively large explicit MOS capacitors are introduced at the output nodes of each delay cell.

The asynchronous comparator 112 (see Figure 1) then converts the differential outputs of the ring oscillator 108, that is alternating between Vth,n-p and Vth,n-p+Vov,n-p in NMOS and PMOS process sensing modes, and between Vss and Vss +Itail ×R1 in resistive process sensing mode, into a single-ended output signal 116 compatible with digital logic, providing a rail-to-rail output swing. This functionality is implemented using a rail-to-rail input complementary self-biased amplifier type architecture.

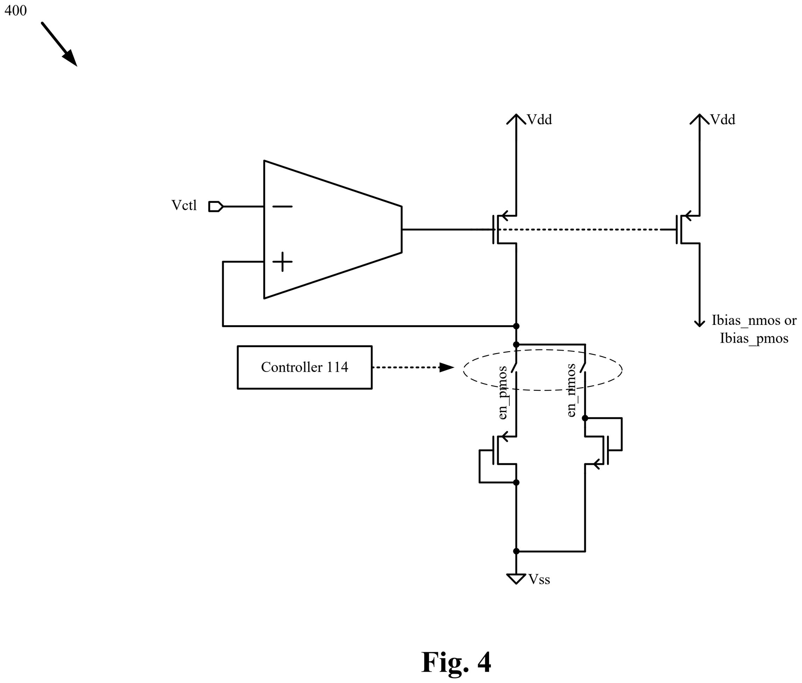

Figure 4 represents an example alternative process sensitive current source 400. The combination process sensitive current source 400 is another example embodiment that can replace the process sensitive current sources 200, 202 shown in Figures 2A, 2B. The combination process sensitive current source 400 is capable of generating the output current source (Ibias_nmos, Ibias_pmos) routed to the switch circuit 104 (see Figure 1) in response to the selected one of the set of process sensitive current sources signals from the controller 114 discussed earlier.

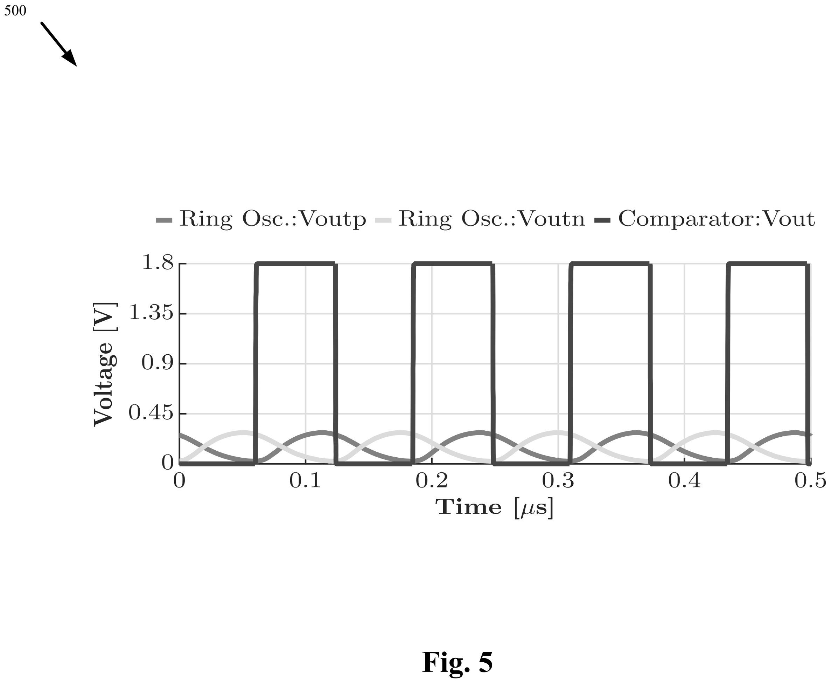

Figure 5 represents example process sensor circuit output signal 116 waveforms 500. The example output signal 116 waveforms 500 show the Voutn and Voutp differential outputs from the buffer cell 110 going into the comparator 112, and the output signal 116 from the comparator 112. In this example the Vdd supply voltage is 1.8 V, the output signal 116 swing is rail-to-rail. Further, the rise and fall times are quite small and the duty cycle is close to 50%.

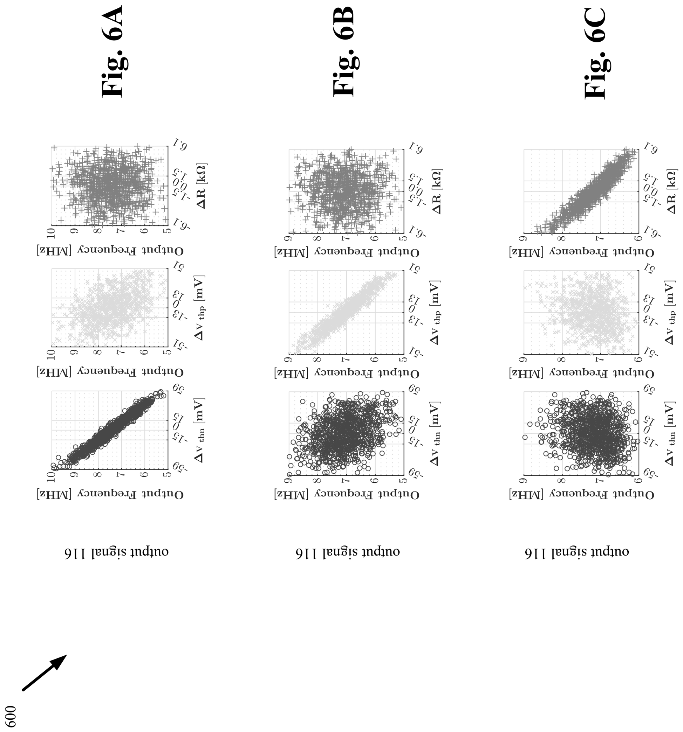

Figures 6A, 6B, 6C represent example correlations between the process sensor circuit's 100 output signal 116 frequency and process parameters that are being tracked/monitored as selected by controller 114..

Separate Monte-Carlo simulations for various process corners and process corner detection modality 102 are shown.

Figure 6A shows the output signal 116 frequency variation for an NMOS process sensing mode in response to NMOS, PMOS, and resistive process variations. In this mode, it is evident from the plots that the output frequency exhibits a strong correlation with the changing Vth for the NMOS devices. On the other hand, it can clearly be observed that the output frequency has no correlation with the PMOS or resistance process shifts.

The weak correlation between the NMOS mode output frequency and PMOS process parameter shifts is due to common process parameter shifts.

Figure 6B shows the output signal 116 frequency variation for an PMOS process sensing mode in response to NMOS, PMOS, and resistive process variations. In this mode, it is evident from the plots that the output frequency exhibits a strong correlation with the changing Vth for the PMOS devices. On the other hand, it can clearly be observed that the output frequency has no correlation with the NMOS or resistance process shifts.

The a weak correlation between the PMOS mode output frequency and NMOS process parameter shifts is due to common process parameter shifts.

Figure 6C shows the output signal 116 frequency variation for a resistive process sensing mode in response to NMOS, PMOS, and resistive process variations. In this mode, it is evident from the plots that the output frequency exhibits a strong correlation with the changing Rsheet for the Resistive devices.

On the other hand, it can clearly be observed that the output frequency has no correlation with the PMOS or NMOS process shifts.

These Monte Carlo simulation results show that the output signal 116 frequency has an over 95% correlation with the process variation being monitored, provided that a correct one of the process sensitive current sources 102 is selected by the controller 114.

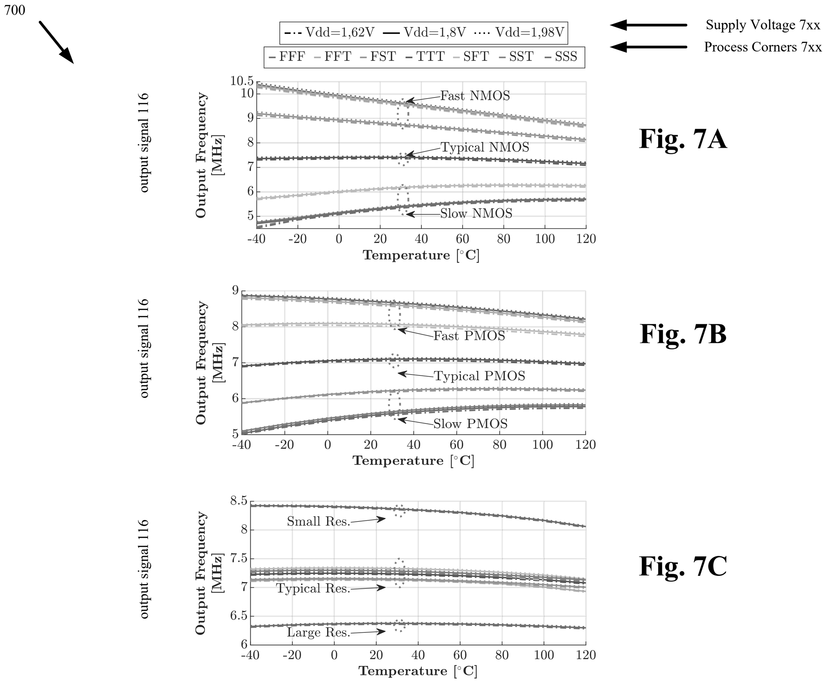

Figures 7A, 7B, 7C represent example behavior of the process sensor output signal 116 frequency for three modalities (i.e. NMOS, PMOS, Resistive) and operating under different corners, supply voltages and temperature.

The process corners are defined over a three-dimensional space comprising NMOS, PMOS and resistances. Each corner is denoted by a three-letter tuple F, T, S indicating fast (F), typical (T), or slow (S) behavior for NMOS, PMOS, and passive devices, respectively (e.g., FFF, FFT, FST, TTT, SFT, SST, SSS).

Dependency of the process sensor output signal 116 frequency on the temperature, is minimized by the process sensor circuit 100 for the typical-typical corner (TTT). A slight increase and decrease on the output frequency is observed for slower and faster corners, respectively.

In Figure 7A (i.e. NMOS process sensing mode) it can be seen that FFF, FFT and FST corners result in higher output frequency than TTT, whereas SFT, SST and SSS correspond to lower output frequencies. This is also true for Figure 7B (i.e. PMOS process sensing mode), however the positions of FST and SFT are toggled. Figure 7C (i.e. resistive process sensing mode) has all MOS corners closer to the TTT; however, FFF and SSS corners are clearly distinguishable.

In many example embodiments the functionality described above is implemented using logic gates, application specific chips, firmware, and/or other hardware. However in some example embodiments this functionality can be implemented as a set of software instructions stored in a non-transitory computer-readable or computer-usable medium.

Various systems, such as the controller 114 just discussed, can host these instructions. Such systems can include an input/output data interface, a processor, a storage device, and a non-transitory machine-readable storage medium. The machine-readable storage medium includes the instructions which control how the processor receives input data and transforms the input data into output data, using data within the storage device. The machine-readable storage medium in an alternate example embodiment is a non-transitory computer-readable storage medium. In other example embodiments the set of instructions described above can be implemented either using logic gates, application specific chips, firmware, as well as other hardware forms.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

If used herein, "predefined" is equivalent to "predetermined" and indicates a value or setting that is tuned for a particular application/embodiment/instance of the described and/or claimed subject matter.

**Claims**

**1.** A process sensor, comprising:

a set of process sensitive current sources having a set of transistors embedded in a semiconductor device;
wherein the process sensitive current sources are configured to generate an output current that varies in response to a process parameter shift of the transistors in the semiconductor device;
a ring oscillator coupled to receive the output current from the set of process sensitive current sources;
wherein the ring oscillator is configured to generate an output signal having a frequency that varies in response to the output current.

**2.** The process sensor of claim 1:
wherein the set of process sensitive current sources include an NMOS process sensitive current source.

**3.** The process sensor of claim 1 or claim 2:
wherein the set of process sensitive current sources include a PMOS process sensitive current source.

**4.** The process sensor of any preceding claim:
wherein the set of process sensitive current sources include a resistance process sensitive current source.

**5.** The process sensor of claim 4:
wherein a resistance in the resistance process sensitive current source is formed from a switched-capacitance device.

**6.** The process sensor according to any preceding claim:
wherein the process sensitive current sources are beta-multiplier current sources.

**7.** The process sensor according to any preceding claim:
wherein the process sensitive current sources are PTAT (proportional to absolute temperature) current sources.

8. The process sensor according to any preceding claims:
   further comprising a controller configured to select which one of the set of process sensitive current sources is routed to the ring oscillator.

9. The process sensor of claim 8:

   wherein the controller is configured to receive a first command to route a first one of the set of process sensitive current sources to the ring oscillator so that the frequency of the output signal corresponds to a first set of process corners of a first sub-set of the transistors; and
   wherein the controller is configured to receive a second command to route a second one of the set of process sensitive current sources to the ring oscillator so that the frequency of the output signal corresponds to a second set of process corners a second sub-set of the transistors.

10. The process sensor of claim 9:
    wherein the controller is configured to receive a third command to route a third one of the set of process sensitive current sources to the ring oscillator so that the frequency of the output signal corresponds to a third set of process corners of a set of polysilicon resistors.

11. The process sensor of claim 9:
    wherein the controller is configured to receive a third command to route a third one of the set of process sensitive current sources to the ring oscillator so that the frequency of the output signal corresponds to a third set of process corners of a set of switched capacitors configured as a resistance.

12. The process sensor of claim 9:

    wherein the first sub-set of the transistors are NMOS transistor; and
    wherein the second sub-set of the transistors are PMOS transistor.

13. The process sensor according to any preceding claim:

    wherein the first and second set of process corners include typical-typical (TT), fast-fast (FF), slow-slow (SS), fast-slow (FS), and slow-fast (SF); and
    wherein fast and slow refer to a switching speed of NMOS and PMOS transistors in the semiconductor device.

14. The process sensor of claim 13:

    wherein the first and second set of process corners are defined by a three letter tuple F, T, S that indicates a fast (F), a typical (T), or a slow (S) behavior for either the NMOS or PMOS transistors, or a set of polysilicon resistors; and
    wherein the three letter tuples include at least one of: FFF, FFT, FST, TTT, SFT, SST, and SSS.

15. The process sensor according to any preceding claim wherein the ring oscillator is formed from a set of differential delay cells.

**Fig. 1**

200

Vdd

PI2

PI1    1:1    :1

I    I    I

N1    1:N    N2

Vgs1    Vgs2

ΔVgs    Vctl1

Vss

Output to
MUX and
then Delay
Cells

Ibias_nmos

Reference Voltage
Controls Sensitivity
of Current Generator

**NMOS** process sensitive
current generator

# Fig. 2A

202

Reference Voltage
Controls Sensitivity
of Current Generator

Vdd

ΔVgs    Vctl2

Vgs1    Vgs2

PI1    1:N    PI2

I    I

N1    1:1    :1

N2

Vss

Output to
MUX and
then Delay
Cells

Ibias_pmos

I

**PMOS** process sensitive
current generator

# Fig. 2B

204

Vdd

ΔVgs
Rdgn

Vgs1    Vgs2

PI1    1:N    PI2

I    I

N1    1:1    :1

N2

Vss

Output to
MUX and
then Delay
Cells

Ibias_res

I

Resistive (RES)
process sensitive
current generator

# Fig. 2C

300

Bias voltage generated by the current mirror 106 based on selected current source 102

Vtail

Vdd

Vinp

Voutp

Vinn

Voutn

Controller 114

en_nmos

en_pmos

en_res

en_res

en_pmos

en_nmos

Vss

**Fig. 3**

EP 4 756 443 A2

400

Vctl

Vdd

Vdd

Controller 114

en_pmos

en_nmos

Ibias_nmos or
Ibias_pmos

Vss

**Fig. 4**

EP 4 756 443 A2

500

**Fig. 5**

Fig. 6A

Fig. 6B

Fig. 6C

Supply Voltage 7xx

Process Corners 7xx

**Fig. 7A**

**Fig. 7B**

**Fig. 7C**

--- Vdd=1,62V — Vdd=1,8V ···· Vdd=1,98V

– FFF – FFT – FST – TTT – SFT – SST – SSS

Fast NMOS

Typical NMOS

Slow NMOS

Output Frequency [MHz]

Temperature [°C]

output signal 116

Fast PMOS

Typical PMOS

Slow PMOS

Output Frequency [MHz]

Temperature [°C]

output signal 116

Small Res.

Typical Res.

Large Res.

Output Frequency [MHz]

Temperature [°C]

output signal 116

700